(19) Europäisches Patentamt
European Patent Office
Office européen des brevets

(11) **EP 0 878 727 A2**

(12) **EUROPÄISCHE PATENTANMELDUNG**

(43) Veröffentlichungstag:
18.11.1998 Patentblatt 1998/47

(51) Int. Cl.⁶: **G02B 27/09**

(21) Anmeldenummer: 98102379.9

(22) Anmeldetag: 11.02.1998

(84) Benannte Vertragsstaaten:
**AT BE CH DE DK ES FI FR GB GR IE IT LI LU MC NL PT SE**
Benannte Erstreckungsstaaten:
**AL LT LV MK RO SI**

(30) Priorität: 27.03.1997 DE 19713187

(71) Anmelder:
**SIEMENS AKTIENGESELLSCHAFT**
**80333 München (DE)**

(72) Erfinder:
• **Heise, Gerhard, Dr.**
**81739 München (DE)**
• **März, Reinhard, Dr.**
**81667 München (DE)**
• **Michel, Herbert**
**81547 München (DE)**

(54) **Vorrichtung zur Umsetzung mehrerer Lichtstrahlen in eine kompaktere Anordnung dieser Lichtstrahlen**

(57) Die Vorrichtung besteht aus übereinander angeordneten flächigen lichtleitenden Schichten (1) mit je einer Einkoppelendfläche (11) zum Einkoppeln und Auskoppelendfläche (12) zum Auskoppeln je eines Lichtstrahls (13), wobei mit den Schichten sowohl die Ein- als auch Auskoppelendflächen übereinander angeordnet sind, sich in jeder Schicht der eingekoppelte kleinere Lichtstrahl frei ausbreiten kann und die aus allen Auskoppelendflächen übereinander ausgekoppelten Lichtstrahlen gemeinsam die kompaktere Anordnung (14) bilden. Einfache Herstellung.

EP 0 878 727 A2

## Beschreibung

Die Erfindung betrifft eine Vorrichtung zur Umsetzung mehrerer Lichtstrahlen in eine kompaktere Anordnung dieser Lichtstrahlen nach dem Oberbegriff des Patentanspruchs 1.

Eine Vorrichtung der genannten Art ist aus der DE-A-19 612 673 (GR 96 P 1328 DE) bekannt. Bei dieser bekannten Vorrichtung bestehen die mehreren lichtleitenden Schichten aus langgestreckt streifenartigen optischen Wellenleitern, deren Einkoppelendflächen und dementsprechend deren an diese Flächen grenzenden Endabschnitte in einer gemeinsamen, zur bestimmten Ebene parallelen Ebene in einem vorbestimmten Abstand nebeneinander angeordnet sind. Dagegen sind die Auskoppelendflächen und dementsprechend die an diese Flächen grenzenden Endabschnitte dieser Wellenleiter in Richtung senkrecht zur bestimmten Ebene übereinander gestapelt.

Jeder Wellenleiter, dessen Einkoppelendfläche parallel zur bestimmten Ebene seitlich gegen die Auskoppelendfläche dieses Wellenleiters versetzt ist, weist eine leicht S-förmige Krümmung auf, die um so stärker ausgeprägt ist, desto größer der seitliche Abstand der Einkoppelendfläche von den Auskoppelendflächen dieses Wellenleiters ist.

Der vorbestimmte Abstand der Einkoppelendflächen der Wellenleiter entspricht dem zur bestimmten Ebene parallelen vorbestimmten Abstand, in dem sich die durch diese Endflächen in die Wellenleiter einzukoppelnden und zu kompaktifizierenden Lichtstrahlen voneinander ausbreiten.

Bei der Herstellung dieser bekannten Vorrichtung ist eine manuelle Präparation erforderlich, bei der die einzelnen Wellenleiter an ihren Auskoppelendflächen aufeinandergelegt werden.

Die im Anspruch 1 angegebene Erfindung hat den Vorteil, daß eine Vorrichtung der eingangs genannten Art bereitgestellt ist, bei der ein manuelles Aufeinanderlegen der mehreren Schichten vermieden ist. Die erfindungsgemäße Vorrichtung kann vorteilhafterweise von vornherein in Form eines Schichtenstapels erzeugt werden, der problemlos mit herkömmlichen einfachen Verfahren hergestellt werden kann.

Bei der erfindungsgemäßen Vorrichtung sind die lichtleitenden Schichten nicht wie bei der bekannten Vorrichtung langgestreckt streifenförmige optische Wellenleiter, die eine Lichtausbreitung nur in deren Längsrichtung und nicht quer dazu erlauben und größtenteils von einer Ebene gekrümmt in eine andere führen, sondern jeweils ebene flächige Schichten, in deren jeder das Licht nur zwischen den beiden Flachseiten dieser Schicht geführt ist, sich aber parallel zur Schichtebene dieser Schicht nach allen Richtungen frei ausbreiten kann, so daß keine Führung des Lichts in einer bestimmten Richtung parallel zu der zur bestimmten Ebene parallelen Schichtebene dieser Schicht vorhanden ist.

Die Einkoppelendflächen der erfindungsgemäßen Vorrichtung sind nicht wie bei der bekannten Vorrichtung parallel zur bestimmten Ebene nebeneinander, sondern in Richtung senkrecht zur bestimmten Ebene übereinander angeordnet.

Die Lichtstrahlen sind unter Beibehaltung ihres zur bestimmten Ebene parallelen Abstandes voneinander durch die Einkoppelendflächen in die Schichten einzukoppeln. Da die Einkoppelendflächen in Richtung senkrecht zur bestimmten Ebene übereinander angeordnet sind, bedeutet dies, daß die einzukoppelnden Lichtstrahlen sich nicht wie bei der bekannten Vorrichtung in einer zur bestimmten Ebene parallelen Ebene ausbreiten können, sondern in Richtung senkrecht zur bestimmten Ebene gegeneinander versetzt sein müssen.

Die Einkoppelendflächen müssen bei der erfindungsgemäßen Vorrichtung vorteilhafterweise nicht eigens gestaltet werden. Es genügt, wenn sie in Richtung parallel zur bestimmten Ebene eine ausreichende Länge aufweisen.

In jeder Schicht ist eine Strahlumlenkeinrichtung ausgebildet, die den in dieser Schicht geführten eingekoppelten Lichtstrahl so zur Auskoppelendfläche dieser Schicht umlenkt, daß die von allen Strahlumlenkeinrichtungen umgelenkten Lichtstrahlen in der Richtung senkrecht zur bestimmten Ebene übereinander auf die Auskoppelendflächen treffen.

Die Strahlumlenkeinrichtung der erfindungsgemäßen Vorrichtung kann auf verschiedene Weise realisiert werden. Es sei darauf hingewiesen, daß bei der eingangs erläuterten bekannten Vorrichtung bereits eine Strahlumlenkeinrichtung in Form einer leicht S-förmigen Krümmung eines langgestreckt streifenartigen Wellenleiters vorhanden ist. Bei der erfindungsgemäßen Vorrichtung wäre denkbar, in einer lichtleitenden Schicht eine Strahlumlenkeinrichtung in Form eines lokal in dieser Schicht ausgebildeten gekrümmten streifenartigen Wellenleiters vorzusehen.

Bevorzugter und vorteilhafterweise ist jedoch bei der erfindungsgemäßen Vorrichtung eine Strahlumlenkeinrichtung so ausgebildet, wie es im Anspruch 2 angegeben ist, wobei die reflektierende Fläche dieser Strahlumlenkeinrichtung vorteilhafterweise durch Ätzen oder durch lokale Diffusion oder Implantation von die Brechzahl der betreffenden lichtleitenden Schicht verändernden Dotierstoffen erzeugt werden kann.

Nicht zuletzt dazu ist es vorteilhaft, eine erfindungsgemäße Vorrichtung so zu auszubilden wie es im Anspruch 3 angegeben ist. Diese Ausgestaltung hat den Vorteil, daß die weiteren Endflächen der lichtleitenden Schichten zur Ausbildung der jeweiligen Strahlumlenkeinrichtung frei zugänglich sind und nicht erst freigelegt werden müssen. Auch die Herstellung dieser weiteren Endflächen kann vorteilhafterweise sehr einfach durch Abschleifen des aus den lichtleitenden Schichten bestehenden Schichtenstapels schräg im Winkel zur bestimmten Ebene und Polieren der schrägen Schlifffläche erfolgen. Die weiteren Endflächen sind in diesem Fall vorteilhafterweise alle in der polierten Schlifffläche angeordnet, die vorzugsweise eine Ebene definiert.

Überdies besteht der Vorteil, daß im Bereich der zu den Schichtebenen schrägen weiteren Endflächen die Schichtdicke der lichtleitenden Schichten reduziert ist. Dies erleichtert die Herstellung der reflektierenden Fläche durch Ätzen oder Diffusion oder Implantation, da im Bereich jeder Endfläche die Ätz-, Diffusions- und Implantationstiefe reduziert ist.

Jeder in eine lichtleitende Schicht eingekoppelte Lichtstrahl kann sich in der jeweiligen Schicht konvergent, divergent oder als Parallelstrahl ausbreiten, so daß er sich in seiner zur bestimmten Ebene parallelen Ausbreitungsrichtung zunehmend verschmälert, verbreitert bzw. in seiner Breite im wesentlichen konstant bleibt.

Die erfindungsgemäße Vorrichtung weist vorteilhafterweise gemäß Anspruch 6 eine Strahlformungseinrichtung zur Formung des in dieser Schicht geführten und sich parallel zur bestimmten Ebene ausbreitenden Lichtstrahls auf. Mit einer solchen Strahlformungseinrichtung können die Divergenz, Konvergenz und Parallelität eines in einer Schicht geführten Lichtstrahls verändert, insbesondere auch ineinander umgewandelt werden. Insbesondere besteht mit einer solchen Strahlformungseinrichtung vorteilhafterweise die Möglichkeit, ein Lichtaustrittsfenster, aus dem ein in eine lichtleitende Schicht durch dessen Einkoppelendfläche einzukoppelnder Lichtstrahl austritt, beispielsweise ein Lichtaustrittsfenster eines Lasers, mit einem wählbaren Abbildungsmaßstab reell abzubilden. Die Strahlformungseinrichtung wirkt in diesem Fall als eine Abbildungsoptik und mit der erfindungsgemäßen Vorrichtung können auf diese Weise mit Abstand voneinander angeordnete Lichtaustrittsfenster reell in einer kompakteren Anordnung abgebildet werden.

Eine solche Strahlformungseinrichtung kann vorteilhafterweise in Form der in dieser Schicht ausgebildeten Strahlumlenkeinrichtung in Form der reflektierenden Fläche bestehen, die parallel zur bestimmten Ebene gekrümmt verläuft. In diesem Fall bilden die Strahlumlenkeinrichtung und die Strahlformungseinrichtung einer lichtleitenden Schicht vorteilhafterweise eine Einheit, die ebenso einfach wie die Strahlumlenkeinrichtung dieser Schicht allein realisiert werden kann.

Zwei benachbarte lichtleitende Schichten sind vorteilhafterweise gemäß Anspruch 9 durch eine zwischen diesen Schichten angeordnete Schicht mit einem im Vergleich zu einer Brechzahl dieser lichtleitenden Schichten kleineren Brechzahl getrennt. Diese Schicht kleinerer Brechzahl bildet sparsamerweise eine optische Mantelschicht für beide lichtleitenden Schichten. Die lichtleitenden Schichten selbst können Schichten mit kontinuierlichem Modenspektrum, Multimode-Wellenleiterschichten und Monomode-Wellenleiterschichten sein, die jeweils bekannt sind und auf bekannte Weise hergestellt werden können. Alle bekannten Herstellungsverfahren können angewendet werden.

Weitere bevorzugte und vorteilhafte Ausgestaltungen der erfindungsgemäßen Vorrichtung gehen aus den Unteransprüchen 4 und 5 hervor.

Die erfindungsgemäße Vorrichtung ist vorteilhaft zur Umsetzung der von mehreren Halbleiterlasern erzeugten und mit vorbestimmtem zur bestimmten Ebene parallelen Abstand voneinander sich ausbreitenden divergenten Lichtstrahlen in eine relativ kompaktere Anordnung dieser Lichtstrahlen, die beispielsweise in einen optischen Multimode-Wellenleiter, insbesondere eine Multimodefaser einkoppelbar ist, anwendbar (Anspruch 10).

In dieser Anwendung ist die erfindungsgemäße Vorrichtung vorteilhafterweise in der Schweiß- und Löttechnik, in der Medizin und/oder in der Drucktechnik einsetzbar, bei welchen Einsatzmöglichkeiten möglichst viel optische Leistung, insbesondere in der Größe mehrerer Watt, an den Einsatzort zu bringen ist, beispielsweise über den Multimode-Wellenleiter. Der optischen Leistung eines einzelnen Halbleiterlasers sind insbesondere durch die Belastbarkeit seiner Lichtaustrittsfläche und durch die Stromdichte im Laser Grenzen gesetzt. Mit der erfindungsgemäßen Vorrichtung sind durch Kombination der optischen Leistungen mehrerer einzelner Halbleiterlaser, insbesondere einzelner Leistungs-Halbleiterlaser, mehrere Watt optische Leistung erzielbar, so daß eine Leistungslaseranordnung besonders hoher Leistung realisierbar ist.

Umgekehrt ist die erfindungsgemäße Vorrichtung, insbesondere in der Ausführungsform nach Anspruch 6, zur Umsetzung eines Lichtstrahls größeren Strahlquerschnitts, der beispielsweise aus einem Multimode-Wellenleiter, insbesondere eine Multimodefaser austritt, in mehrere mit Abstand voneinander sich ausbreitenden Teilstrahlen jeweils kleineren Strahlquerschnitts anwendbar, wobei die Auskoppelendflächen zum Einkoppeln des Lichtstrahls des größeren Strahlquerschnitts in die lichtleitenden Schichten und die Einkoppelendflächen zum Auskoppeln der Teilstrahlen des jeweils kleineren Strahlquerschnitts zu verwenden sind (Anspruch 11).

Die Erfindung wird in der nachfolgenden Beschreibung an Hand der Figuren beispielhaft näher erläutert. Es zeigen:

Figur 1 in perspektivischer Darstellung eine bevorzugte Ausführungsform der erfindungsgemäßen Vorrichtung, die zur Umsetzung der von einer Zeile aus Halbleiterlasern erzeugten Lichtstrahlen in eine kompaktere Anordnung der Lichtstrahlen derart, daß sie in eine Multimodefaser einkoppelbar sind, geeignet ist,

Figur 2 eine Draufsicht auf die Einkoppelendflächen der lichtleitenden Schichten der Ausführungsform nach Figur 1 und der davor angeordneten Zeile aus Halbleiterlasern,

Figur 3    eine Draufsicht senkrecht zur bestimmten Ebene auf die schräg im Winkel zu den Schichtebenen und den Einkoppelendflächen angeordneten weiteren Endflächen der lichtleitenden Schichten der Ausführungsform nach Figur 1,

Figur 4    eine Draufsicht senkrecht zur bestimmten Ebene auf die schräg im Winkel zu den Schichtebenen und senkrecht den Einkoppelendflächen der Schichten angeordneten weiteren Endflächen der lichtleitenden Schichten einer anderen möglichen Ausführungsform der erfindungsgemäßen Vorrichtung, und

Figur 5    eine Draufsicht senkrecht zur bestimmten Ebene auf die schräg im Winkel zu den Schichtebenen und senkrecht den Einkoppelendflächen der Schichten angeordneten weiteren Endflächen der lichtleitenden Schichten der anderen möglichen Ausführungsform nach Figur 4, die eine modifizierte Strahlumlenkeinrichtung aufweist.

Die Figuren sind schematisch und nicht maßstäblich.

In den Figuren sind die mehreren lichtleitenden Schichten mit 1, deren Einkoppelendflächen mit 11 und deren Auskoppelendflächen mit 12 bezeichnet. Die vorhandenen weiteren Endflächen der lichtleitenden Schichten 1 sind mit 15 bezeichnet. Die vorhandenen Strahlumlenkeinrichtungen sind generell mit 17 und die vorhandenen Strahlformungseinrichtungen sind generell mit 18 bezeichnet.

Die von der erfindungsgemäßen Vorrichtung in die kompaktere Anordnung 14 umzusetzenden Lichtstrahlen, deren jeder in je eine der lichtleitenden Schichten 1 durch deren Einkoppelendfläche 11 einzukoppeln, in dieser Schicht 1 nach einer Umlenkung an der Strahlumlenkeinrichtung 17 dieser Schicht 1 zu deren Auskoppelendfläche 12 geführt und an dieser Auskoppelendfläche 12 ausgekoppelt ist, sind jeweils mit 13 bezeichnet.

Bei sämtlichen Ausführungsformen sind jeweils zwei benachbarte lichtleitende Schichten 1 durch eine zwischen diesen beiden Schichten 1 angeordnete Zwischenschicht 2 getrennt, die eine im Vergleich zu einer Brechzahl n1 dieser beiden lichtleitenden Schichten 1 kleinere Brechzahl n2 aufweist. Die Brechzahlen n1 und n2 der lichtleitenden Schichten 1 und Zwischenschichten 2 sind möglichst so zu wählen, daß eine optische Kopplung zwischen den lichtleitenden Schichten 1 möglichst gering ist.

An jede lichtleitende Schicht 1 muß beidseitig ein optisches Medium mit einer im Vergleich zur Brechzahl dieser Schicht 1 kleineren Brechzahl grenzen, das bei allen Schichten 1 aus den Schichten 2 der kleineren Brechzahl n2 bestehen kann.

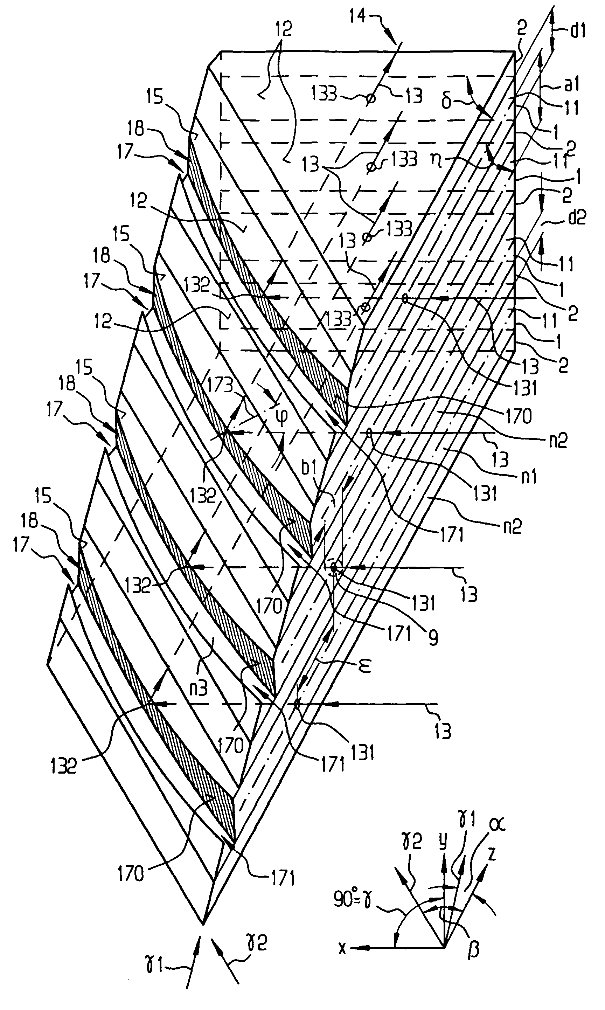

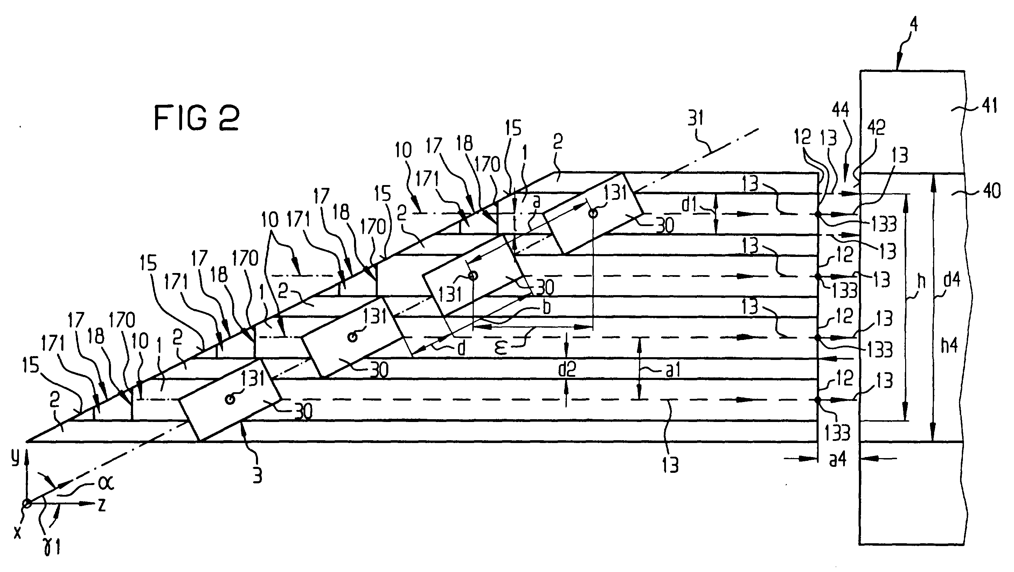

Die in den Figuren 1 und 2 jeweils durch eine strichpunktierte Linie angedeuteten, mit 10 bezeichneten und zueinander parallelen Schichtebenen der lichtleitenden Schichten 1 sind parallel zu einer durch die beiden Richtungen x und z eines in allen Figuren eingezeichneten rechtwinkligen Koordinatenkreuzes (x, y, z) aufgespannten Koordinatenebene (x, z) angeordnet. Die Koordinatenebene (x, z) bildet die bestimmte Ebene.

In der Figur 2 ist die Darstellung so, daß die von den Richtungen y und z aufgespannte und zur bestimmten Ebene (x, z) senkrechte Koordinatenebene (y, z) parallel zur Zeichenebene ist, so daß sowohl die bestimmten Ebene (x, z) und mit dieser die Schichtebenen 10 selbst als auch die durch die Richtungen x und y aufgespannte Koordinatenebene (x, y) jeweils senkrecht zur Zeichenebene stehen.

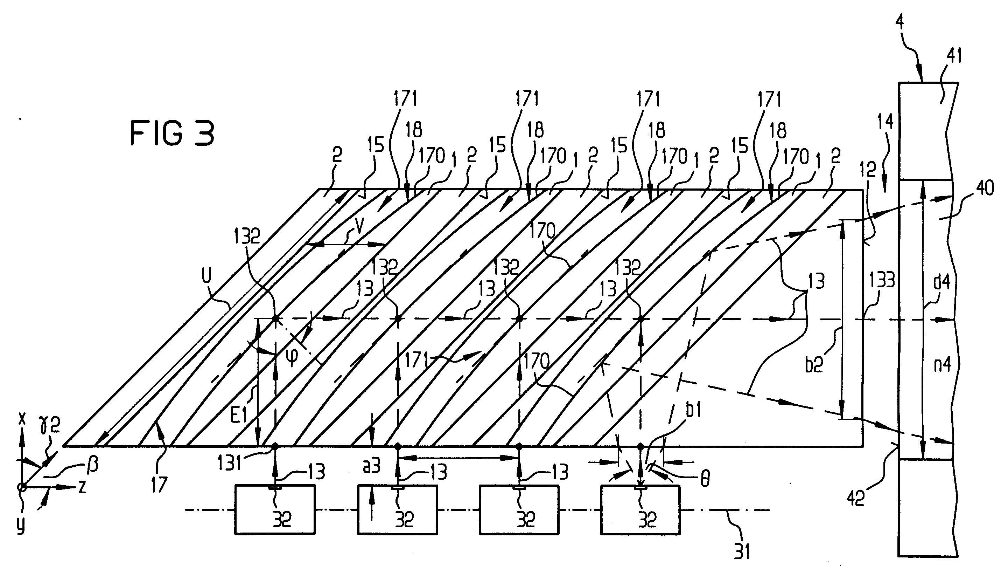

In den Figuren 3 bis 5 sind dagegen die bestimmten Ebene (x, z) und mit dieser die Schichtebenen 10 parallel zur Zeichenebene dargestellt, so daß die anderen Koordinatenebenen (y, z) und (x, y) jeweils senkrecht zur Zeichenebene stehen.

Überdies ist in den Figuren 2 bis 5 die Darstellung so, daß in der Figur 2 die senkrecht zur Zeichenebene stehende bestimmten Ebene (x, z) horizontal und dementsprechend die senkrecht zur Zeichenebene stehende Koordinatenebene (x, y) vertikal und in den Figuren 3 bis 5 jeweils die senkrecht zur Zeichenebene stehende Koordinatenebene (y, z) horizontal und dementsprechend die senkrecht zur Zeichenebene stehende Koordinatenebene (x, y) vertikal angeordnet ist.

Die Einkoppelendfläche 11 jeder lichtleitenden Schicht 1 ist vorteilhafterweise so angeordnet, daß sie in einem Winkel $\gamma$ zur bestimmten Ebene (x, z) angeordnet ist, der bei den dargestellten Ausführungsformen vorzugsweise 90° beträgt und der Winkel zwischen der zur bestimmten Ebene (x, z) parallelen Richtung x und zur bestimmten Ebene (x, z) senkrechten Richtung y ist.

Ohne Beschränkung der Allgemeinheit sei die Einkoppelendfläche 11 jeder lichtleitenden Schicht 1 im folgenden parallel zur Koordinatenebene (y, z).

Die Auskoppelendfläche 12 jeder lichtleitenden Schicht 1 steht bei allen Ausführungsformen in einem Winkel $\delta$ zur Einkoppelendfläche 11 dieser Schicht 1 und in einem Winkel $\eta$ zur bestimmten Ebene (x, z). Der Winkel $\delta$ beträgt vorzugsweise 90° und ist mit dem Winkel zwischen der jeweils zur bestimmten Ebene (x, z) parallelen Richtung x und Richtung z identisch und Winkel $\eta$ beträgt vorzugsweise ebenfalls 90° und ist mit dem Winkel zwischen der zur bestimmten Ebene (x, z) senkrechten Richtung y und der zur bestimmten Ebene (x, z) parallelen Richtung z identisch, so daß in diesem speziellen Fall die Auskoppelendfläche 12 jeder lichtleitenden Schicht 1 parallel zur Koordinatenebene (x, y) ist.

Die weitere Endfläche 15 jeder lichtleitenden Schicht 1 ist bei allen Ausführungsformen schräg in einem Winkel $\alpha$ zur bestimmten Ebene (x, z) und in einem Winkel $\beta$ zur Einkoppelendfläche 11 dieser Schicht 1 angeordnet. Der Winkel $\alpha$ sei in der Koordinatenebene (y, z), zu der die Einkoppelendfläche 11 dieser Schicht 1 parallel ist, der Winkel $\beta$ in der Koordinatenebene (x, z), zu der die Schichtebene 10 dieser Schicht 1 parallel ist, gemessen.

Die Winkel $\gamma$, $\delta$, $\eta$ und insbesondere $\alpha$ und $\beta$ sind neben der Schichtdicke und Brechzahl der lichtleitenden Schichten 1 und Schichten 2 weitgehend frei wählbare Designparameter, so daß bei der erfindungsgemäßen Vorrichtung vorteilhafterweise ein hoher Freiheitsgrad zur Anpassung dieser Vorrichtung an die konkreten Gegebenheiten des Einzelfalls besteht. Jeder ausgewählte Parameter ist bis auf jeweils vorgebbare zulässige Toleranzen genau einzuhalten.

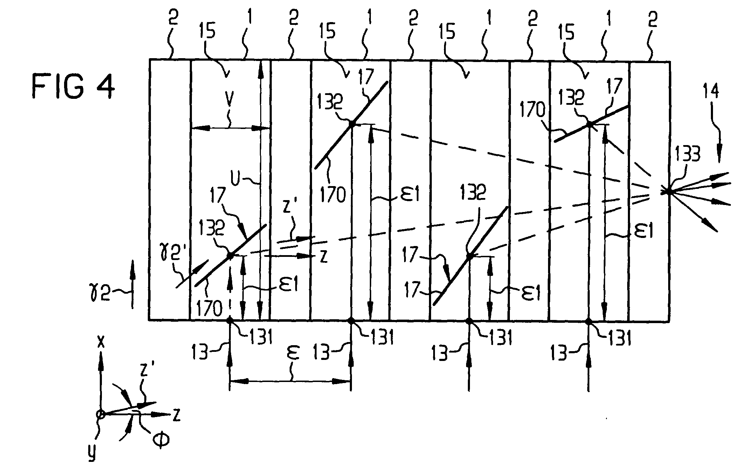

Die Ausführungsform nach den Figuren 1 bis 3 unterscheidet sich von den Ausführungsformen nach den Figuren 4 bis 5 dadurch, daß bei der erstgenannten Ausführungsform die weitere Endfläche 15 jeder lichtleitenden Schicht 1 nicht nur schräg im Winkel $\alpha$ < 90° zur bestimmten Ebene (x, z), sondern auch schräg im Winkel $\beta$ < 90° zur Einkoppelendfläche 11 dieser Schicht 1 angeordnet ist, während bei den zweitgenannten Ausführungsformen die weitere Endfläche 15 jeder lichtleitenden Schicht 1 in dem Winkel $\beta$ = 90°, also senkrecht zur Einkoppelendfläche 11 dieser Schicht 1 angeordnet ist.

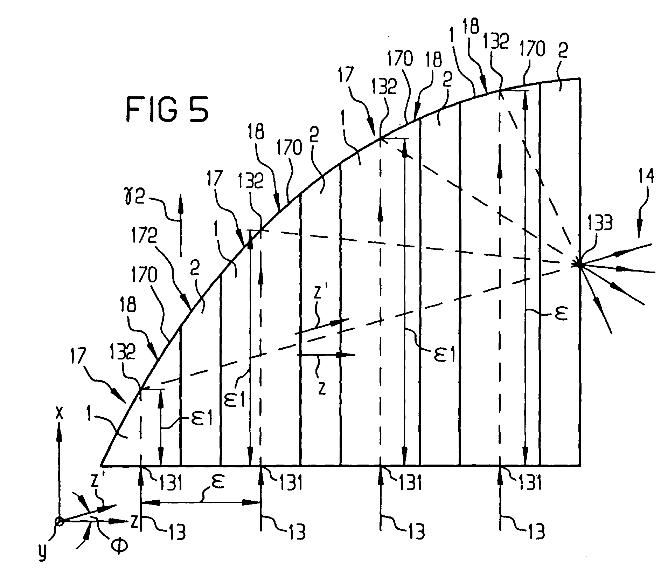

Bei allen Ausführungsformen seien, wie in den Figuren dargestellt, vorteilhafterweise die Einkoppelendflächen 11, die Auskoppelendflächen 12 und die weiteren Endflächen 15 jeweils zusammen in einer gemeinsamen Ebene und nicht in voneinander verschiedenen Ebenen angeordnet. Unter diesen speziellen Gegebenheiten ist die gemeinsame Ebene der Einkoppelendflächen 11 parallel zur Koordinatenebene (y, z), die gemeinsame Ebene der Auskoppelendflächen 12 parallel zur Koordinatenebene (x, y) und die gemeinsame Ebene der weiteren Endflächen 15 zumindest schräg im Winkel $\alpha$ zur bestimmten Ebene (x, z) angeordnet. Beim Ausführungsbeispiel nach den Figuren 1 bis 3 ist die gemeinsame Ebene der weiteren Endflächen 15 zusätzlich schräg im Winkel $\beta$ < 90°, bei den Ausführungsbeispielen nach den Figuren 4 und 5 dagegen im Winkel $\beta$ = 90° zur Koordinatenebene (y, z) angeordnet.

In diesem Fall ist

- durch die Schnittlinie der Ebene der Einkoppelendflächen 11 und der dazu im Winkel stehenden Ebene der weiteren Endflächen 15 eine zu der Koordinatenebene (y, z) parallele Richtung r1 definiert, die in dieser Koordinatenebene (y, z) den Winkel $\alpha$ mit der zur bestimmten Ebene (x, z) parallelen Richtung z einschließt,

und

- durch die Schnittlinie der zur bestimmten Ebene (x, z) parallelen Schichtebene 10 jeder lichtleitenden Schicht 1 und der dazu und zur Ebene der Einkoppelendflächen 11 im Winkel stehenden Ebene der weiteren Endflächen 15 eine zur bestimmten Ebene (x, z) parallele Richtung r2 definiert, in der sich die weiteren Endflächen 15 erstrecken und die in der bestimmten Ebene (x, z) den Winkel $\beta$ mit der zur bestimmten Ebene (x, z) parallelen Richtung z einschließt, der kleiner oder gleich 90° ist.

Bei allen Ausführungsformen ist die Strahlumlenkeinrichtung 17 im Bereich der weiteren Endfläche 15 jeder lichtleitenden Schicht 1 ausgebildet, die vorzugsweise eine in dieser Schicht 1 ausgebildete reflektierende Fläche 170 aufweist, die im wesentlichen in der Richtung y senkrecht zur bestimmten Ebene (x, z) angeordnet ist. „Im wesentlichen" bedeutet hier, daß die reflektierende Fläche 170 in einem zulässigen Winkelbereich von der Richtung y senkrecht zur bestimmten Ebene (x, z) abweichen kann, innerhalb dessen gewährleistet ist, daß der durch die in diese in dieser Schicht 1 geführte und an der reflektierenden Fläche 170 reflektierte Lichtstrahl 13 nach der Reflexion weiter in dieser Schicht 1 geführt ist.

Die Größe des zulässigen Winkelbereichs hängt von der Stärke der Lichtführung in der lichtleitenden Schicht 1, insbesondere von deren Brechzahl n1 und der relativ dazu kleineren Brechzahl n2 der beiden an diese Schicht 1 angrenzenden Schichten 2 ab. Beispielsweise kann die reflektierende Schicht 170 einer lichtleitenden Schicht 1 unter Umständen um bis zu 10° nach der einen oder anderen Seite von der Richtung y senkrecht zur bestimmten Ebene (x, z) abweichen.

Eine reflektierende Fläche 170 kann in einer lichtleitenden Schicht 1 u. a. auf einfache Weise dadurch erzeugt werden, daß im Bereich der vorteilhafterweise frei zugänglichen weiteren Endfläche 15 dieser Schicht 1 eine Aussparung oder Vertiefung 171 ( siehe Figuren 1 bis 3) mit einer zur Schichtebene 10 dieser Schicht 1 im wesentlichen senkrechten Flanke erzeugt wird, auf die der durch die Einkoppelendfläche 11 dieser Schicht 1 eingekoppelte und in dieser Schicht 1 parallel zu deren Schichtebene 10 und damit zur bestimmten Ebene (x, z) geführte Lichtstrahl 13 kleineren Strahlquerschnitts q schräg in einem Einfallswinkel $\varphi$ trifft.

Die Aussparung oder Vertiefung 171 muß mit einem Medium einer Brechzahl n3 gefüllt sein, die entweder kleiner oder größer als die Brechzahl n1 der lichtleitenden Schicht 1 ist. Die genannte Flanke der Aussparung oder Vertiefung 171 ist dann eine brechende Fläche, die bei richtiger Wahl der Differenz zwischen der Brechzahl n1 der lichtleitenden Schicht 1 und der Brechzahl n3 des Mediums in der Aussparung oder Vertiefung 171 und des Einfallswinkels $\varphi$, unter dem der Lichtstrahl 13 auf diese brechende Fläche trifft, die reflektierende Fläche 170 bildet.

Beispielsweise kann die Aussparung oder Vertiefung 171 mit Luft gefüllt sein.

Eine reflektierende Fläche 170 einer lichtleitenden Schicht 1 kann beispielsweise auch eine brechende Fläche in Form einer Grenzfläche sein, an der zwei unterschiedlich dotierte Gebiete dieser Schicht 1 aneinandergrenzen, wobei die unterschiedlichen Dotierungen unterschiedlichen Brechzahlen entsprechen.

Auch kann eine reflektierende Fläche 170 eine verspiegelte Fläche, beispielsweise die verspiegelte Flanke der Aussparung oder Vertiefung 171 in einer lichtleitenden Schicht 1 sein. Eine verspiegelte reflektierende Fläche 170 hat den Vorteil, daß sie bei jedem Einfallswinkel $\varphi$ reflektiert, unter dem der zugeführte Lichtstrahl, d. h. dessen Achsstrahl, auf diese verspiegelte Fläche 170 trifft, so daß keine besonderen Winkelbedingungen, beispielsweise die für Totalreflexion, eingehalten werden müssen.

Der Einfallswinkel $\varphi$ ist üblicherweise der Winkel zwischen dem Achsstrahl des Lichtstrahls 13 und der Flächennormale 173 der reflektierenden Fläche 170 im Auftreffpunkt 132 des Achsstrahls auf dieser Fläche 170. Achsstrahl eines Lichtstrahls bedeutet den sich auf der stets definierten optischen Achse dieses Lichtstrahls ausbreitenden Einzelstrahl. Der Achsstrahl eines in einer lichtleitenden Schicht 1 geführten Lichtstrahls 13 ist parallel zur Schichtebene 10 dieser Schicht 1. Die Flächennormale 173 der reflektierenden Fläche 170 einer lichtleitenden Schicht 1 ist im wesentlichen parallel zu den Schichtebenen 10 dieser Schicht 1.

In den Figuren sind die Lichtstrahlen 13 im wesentlichen durch ihre Achsstrahlen dargestellt. In den Figuren trifft jeder Lichtstrahl 13, d. h. dessen Achsstrahl, seine Einkoppelendfläche 11 im Punkt 131, seine reflektierende Fläche 170 im Punkt 132 und seine Auskoppelendfläche 12 im Punkt 133.

Bei der Ausführungsform nach den Figuren 1 bis 3 ist die weitere Endfläche 15 jeder lichtleitenden Schicht 1 vorteilhafterweise speziell so angeordnet, daß der Winkel $\beta$ gleich 45° ist. Da die Ebene der Auskoppelendflächen 12 parallel zur Koordinatenebene (x, y) gewählt ist, schließt die Richtung r2 in der Koordinatenebene (x, z) auch mit der zur bestimmten Ebene (x, z) parallelen Richtung x den Winkel 45° ein.

Bei dieser schrägen Anordnung der weiteren Endfläche 15 jeder lichtleitenden Schicht 1 kann sich die reflektierende Fläche 170 dieser Schicht 1 im Auftreffpunkt 132 des Lichtstrahls 13 auf diese Fläche 170 in der gleichen Richtung r2 wie diese weitere Endfläche 15 erstrecken, d. h in der bestimmten Ebene (x, z) im Winkel von 45° zur Richtung x und Richtung z.

Dies hat den Vorteil

- zum einen, daß der Achsstrahl des in jede lichtleitende Schicht 1 einzukoppelnden Lichtstrahls 13 sich in der Richtung x ausbreitet und die Einkoppelendfläche 11 dieser Schicht 1 senkrecht im Punkt 131 trifft, so daß er ungebrochen, d. h. ohne Ablenkung von der zur bestimmten Ebene (x, z) parallelen Richtung x, in diese Schicht 1 einkoppelt, dieser Achsstrahl die reflektierende Fläche 170 dieser Schicht 1 im Punkt 132 unter dem Einfallswinkel $\varphi =$ 45° trifft, dort um 90° in die zur bestimmten Ebene (x, z) parallele Richtung z senkrecht zur Auskoppelendfläche 12 dieser Schicht 1 umgelenkt und an dieser Auskoppelendfläche 12 im Punkt 133 ungebrochen, d. h. ohne Ablenkung von der zur bestimmten Ebene (x, z) parallelen Richtung z, ausgekoppelt wird,

- zum anderen, daß für diese reflektierende Fläche 170 vorteilhafterweise und wie aus den Figuren 1 und 3 entnehmbar die ganze Abmessung u (siehe Figur 3) dieser weiteren Endfläche 15 in der Richtung r2 zur Verfügung steht, so daß sich diese Fläche 170 über diese ganze Abmessung u erstrecken kann und dadurch auch Lichtstrahlen 13 mit großer Strahlbreite parallel zu den Schichtebenen 10 der lichtleitenden Schichten 1, wie sie beispielsweise bei stark divergenten Lichtstrahlen 13 auftreten können, voll erfassen und umlenken kann.

Die Anordnung der weiteren Endflächen 15 der lichtleitenden Schichten 1 in der Koordinatenebene (y, z) schräg im Winkel $\alpha$ zu der zur bestimmten Ebene (x, z) parallelen Richtung z bei allen Ausführungsformen bedeutet, daß die weiteren Endflächen 15 in dieser Richtung z zueinander versetzt, d.h. in einem Abstand voneinander angeordnet sind. Da die Strahlumlenkeinrichtungen 17 im Bereich der weiteren Endflächen 15 angeordnet sind, sind auch diese und speziell die reflektierenden Flächen 170 in der Richtung z im Abstand voneinander angeordnet.

Dies bedeutet, daß auch die in die lichtleitenden Schichten 1 einzukoppelnden Lichtstrahlen 13 in diesem Abstand in der zur bestimmten Ebene (x, z) parallelen Richtung z voneinander in diese Schichten 1 einzukoppeln sind. Dieser Abstand ist in den Figuren der in der Richtung z und damit parallel zur bestimmten Ebene (x, z) gemessene Abstand $\varepsilon$ zwischen zwei Punkten 131, in denen die Achsstrahlen zweier in benachbarte lichtleitende Schichten 1 einzukoppelnder Lichtstrahlen 13 auf die Einkoppelendflächen 11 dieser beiden Schichten 1 treffen.

Die Einkoppelendflächen 11 müssen in bezug auf dieses zueinander versetzte Einkoppeln der Lichtstrahlen 13 vorteilhafterweise nur die Bedingung erfüllen, daß an der betreffenden Stelle 131 der Einkoppelendfläche 11 einer lichtleitenden Schicht 1 tatsächlich eingekoppelt werden kann.

Dies ist mit Sicherheit gewährleistet, wenn sich, wie aus den Figuren 1 und 2 ersichtlich und bei allen dargestellten Ausführungsformen der Einfachheit halber realisiert, die Einkoppelendfläche 11 jeder lichtleitenden Schicht 1 von der weiteren Endfläche 15 dieser Schicht 1 in der zur bestimmten Ebene (x, z) parallelen Richtung z durchgehend bis zur Auskoppelendfläche 12 dieser Schicht 1 erstreckt. Weitere Maßnahmen, beispielsweise Fenster definierende Masken auf solchen Einkoppelendflächen 11 sind vorteilhafterweise nicht erforderlich, obgleich sie unter Umständen vorhanden sein könnten.

Der zur bestimmten Ebene (x, z) parallele Abstand $\varepsilon$ der in die lichtleitenden Schichten 1 einzukoppelnden Lichtstrahlen 13 ist vorteilhafterweise durch den vorgebbaren Winkel $\alpha$ einstellbar, in welchem die weiteren Endflächen 15 schräg zur bestimmten Ebene (x, z) angeordnet sind. Der Abstand $\varepsilon$ ist dadurch in weiten Grenzen beliebig einstellbar.

Dies ist von großem Vorteil, wie das folgende Beispiel mehrerer in einer Zeile 3 längs einer Geraden 31 aufgereihten Halbleiterlasern 30 (siehe Figuren 2 bis 5) zeigt. Jeder einzelne Laser 30 weist je ein Lichtaustrittsfenster 32 auf, aus dem ein Lichtstrahl 13 divergent austritt. Die Lichtaustrittsfenster 32 sind längs der Geraden 31 mit einem festen, nicht veränderbaren Abstand a voneinander angeordnet und gleich orientiert, so daß sich die aus allen Lichtaustrittsfenstern 32 austretenden divergenten Lichtstrahlen 13 längs der Geraden 32 im festen Abstand a voneinander und in der gleichen Richtung senkrecht zur Geraden 32 ausbreiten.

Sind diese Lichtstrahlen 13 durch die erfindungsgemäße Vorrichtung in eine kompaktere Anordnung umzusetzen, ist jeder Lichtstrahl 13 in je eine lichtleitende Schicht 1 der Vorrichtung einzukoppeln .

Dabei ist zu Bedenken, daß die lichtleitenden Schichten 1 in der zur bestimmten Ebene (x, z) senkrechten Richtung y in einem festen Abstand a1 voneinander angeordnet sind, der ebenfalls nicht veränderbar ist. Der Abstand a1 ist beispielsweise durch den Abstand der zentralen Schichtebenen 10 zweier benachbarter lichtleitender Schichten 1 voneinander definiert.

Die Lichtstrahlen 13 müssen zum Einkoppeln in die lichtleitenden Schichten 1 in der zur bestimmten Ebene (x, z) senkrechten Richtung y in diesem Abstand a1 und gleichzeitig in dem zur bestimmten Ebene (x, z) parallelen vorgegebenen Abstand $\varepsilon$ voneinander auf die Einkoppelendflächen 11 dieser Schichten 1 treffen.

Durch Anordnung der Laser 30 in bezug auf die Einkoppelendflächen 11 der lichtleitenden Schichten 1 so, daß sich die Lichtstrahlen 13 der Laser 30 senkrecht zu den Einkoppelendflächen 11 ausbreiten und die Gerade 31 parallel zu den Einkoppelendflächen 11 und schräg in einem solchen Winkel zur bestimmten Ebene (x, z) angeordnet ist, wird dies erreicht, wenn der mit dem Sinus dieses Winkels multiplizierte Abstand a zwischen Lichtstrahlen 13 den gleich dem Abstand a1 zwischen den lichtleitenden Schichten 1 und der mit dem mit dem Cosinus dieses Winkels multiplizierten Abstand a gleich dem vorgegebenen Abstand $\varepsilon$ ist.

Da der Abstand $\varepsilon$ gleich dem mit cos $\alpha$ multiplizierten und zu den Einkoppelendflächen 11 parallelen Abstand zwischen benachbarten Punkten 132 ist, in denen die Strahlumlenkeinrichtungen 17 benachbarter Schichten 1 von den Lichtstrahlen 13 benachbarter Laser 30 getroffen werden, ist die Gerade 31 in dem gleichen Winkel $\alpha$ zur bestimmten Ebene (x, z) anzuordnen, so daß sich diese Gerade 31 in der oben definierten Richtung r1 erstreckt und a1 = a $\cdot$ sin $\alpha$ und $\varepsilon$ = a $\cdot$ cos $\alpha$ gilt.

Bei Halbleiterlaserzeilen 3 nimmt üblicherweise jeder Laser 30 eine bestimmte Strecke b auf der Geraden 31 ein, die kleiner als der Abstand a zwischen benachbarten Lasern 30 ist, so daß zwischen benachbarten Lasern 30 jeweils eine Lücke d besteht und a = b + d gilt.

Zweckmäßigerweise wird die Schichtdicke d1 jeder lichtleitenden Schicht 1 zumindest annähernd gleich der mit dem Sinus des Winkels der Geraden 31 zur bestimmten Ebene (x, z) multiplizierten Strecke b gewählt und die Dicke d2 jeder Zwischenschicht 2 zwischen benachbarten lichtleitenden Schichten 1 annähernd gleich der mit dem Sinus dieses Winkels multiplizierten Lücke d zwischen zwei Halbleiterlasern 30 gewählt.

Der von einem Halbleiterlaser 30 abgestrahlte Lichtstrahl 13 ist sowohl in Richtung y senkrecht als auch parallel zur bestimmten Ebene (x, z) stark divergent. Wegen der Divergenz des Lichtstrahls 13 in Richtung y senkrecht zur bestimmten Ebene (x, z) sollte, um möglichst viel Laserlicht in eine lichtleitende Schicht 1 einzukoppeln, das Lichtaustrittsfenster 32 des Halbleiterlasers 30 in einem ausreichend kleinen Abstand a3 von der Einkoppelendfläche 11 dieser Schicht 1 angeordnet sein.

In der Figur 3 sind zu beiden Seiten des Achsstrahls gestrichelt auch die beispielsweise auseinanderstrebenden und je nach durchlaufenen Abschnitten unterschiedlicher Brechzahl verschiedene Divergenzwinkel $\theta$ einschließenden Randstrahlen des in die lichtleitende Schicht 1 ein- und ausgekoppelten stark divergenten Lichtstrahls 13 eines Halbleiterlasers 30 beispielhaft und nicht maßstäblich angedeutet.

Ebenfalls zur Vermeidung von Lichtverlusten sollte die numerische Apertur der Einkoppelendfläche 11 jeder lichtleitenden Schicht 1 gut an die Apertur des Halbleiterlasers 30 angepaßt sein, dessen Lichtstrahl 13 in diese Schicht einzukoppeln ist, und die Strahlumlenkeinrichtung 17 dieser Schicht 1, speziell deren reflektierende Fläche 170, sollte sich parallel zur Schichtebene 10 dieser Schicht 1 in Richtung senkrecht zur Ausbreitungsrichtung des Achsstrahls dieses Lichtstrahls 13 jeweils soweit erstrecken, daß sie möglichst das ganze Licht dieses Lichtstrahls 13 erfaßt und in Richtung parallel zur Schichtebene 10 dieser Schicht 1 umgelenkt. Bei der Ausführungsform nach den Figuren 1 bis 3 ist dies optimal realisiert, da sich dort, wie schon erwähnt, eine reflektierende Fläche 170 jeder lichtleitenden Schicht 1 über die ganze Abmessung u in Richtung r2 der weiteren Endfläche 15 dieser Schicht 1 erstrecken kann.

Überdies sollte ebenfalls zur Vermeidung von Lichtverlusten die Auskoppelendfläche 12 einer lichtleitenden Schicht 1 in Richtung parallel zur Schichtebene 10 dieser Schicht 1 eine Abmessung aufweisen, die zumindest so groß wie die parallel zu dieser Schichtebene 10 gemessene Strahlbreite b2 des in dieser Schicht 1 geführten Lichtstrahls 13 beim Auftreffen auf diese Auskoppelendfläche 12 ist, damit alles Licht dieses Lichtstrahls 13 aus dieser Auskoppelendfläche 12 ausgekoppelt werden kann. In diesem Fall ist die Apertur dieser Auskoppelendfläche 12 bei gegebenen Brechzahlen n1 und n2 durch den Divergenz- oder Konvergenzwinkel des Lichtstrahls 13 allein bestimmt.

Die erfindungsgemäße Vorrichtung ist vorteilhaft zur Umsetzung der von einer Halbleiterlaserzeile 3 erzeugten und voneinander getrennten divergenten Lichtstrahlen 13 in eine kompaktere Anordnung 14 dieser Lichtstrahlen verwendbar, die in einen optischen Multimode-Wellenleiter 4, beispielsweise eine Multimodefaser einzukoppeln sind.

In den Figur 2 und 3 ist eine derartige Multimodefaser 4 in Form einer Kern-Mantel-Faser schematisch dargestellt. Die Faser besteht bekanntermaßen aus einem im Querschnitt kreisförmigen Kern 40 einer bestimmten Brechzahl n4 und einem den kreiszylindrischen Umfang des Kerns 40 umgebenden Mantel 41, der eine im Vergleich zur Brechzahl n4 des Kerns 40 kleinere Brechzahl n5 aufweist. Der Kern 40 weist einen Durchmesser d4 auf, der mindestens gleich der Höhe h des aus sämtlichen lichtleitenden Schichten 1 und den dazwischen angeordneten Schichten 2 bestehenden Schichtenstapels und nicht größer als die Breite b2 jedes der aus den Auskoppelendflächen 12 der lichtleitenden Schichten 1 ausgekoppelten Lichtstrahlen 13 ist, die gemeinsam die Anordnung 14 bilden.

Die Höhe h ist gegeben durch k · d1+(k-1) · d2 , wobei k die Anzahl der lichtleitenden Schichten 1, d1 die Schichtdicke der lichtleitenden Schichten 1 und d2 die Schichtdicke der Zwischenschichten 2 bedeutet. Bei den in den Figuren dargestellten Ausführungsformen ist der Übersichtlichkeit halber nur k = 4 gewählt. Eine praktische Realisierung der erfindungsgemäßen Vorrichtung weist eine größere Anzahl k lichtleitende Schichten 1 auf.

Die kompaktere Anordnung der Lichtstrahlen 13 paßt in den Auskoppelendflächen 12 querschnittsmäßig in die Fläche h · b2. Der aus der Auskoppelendfläche 12 jeder lichtleitenden Schicht 1 ausgekoppelten Lichtstrahl 13 hat in dieser Auskoppelendfläche 12 annähernd den Querschnitt d1 · b2 und in der Einkoppelendfläche 11 dieser Schicht 1 höchstens den Querschnitt d1 · b1, wobei b1 die parallel zur bestimmten Ebene (x, z) gemessene Strahlbreite b1 des in diese Schicht 1 eingekoppelten Lichtstrahls 13 ist.

Zumindest in den Auskoppelendflächen 12 setzt sich die kompaktere Anordnung 14 lückenhaft aus den Lichtstrahlen 13 zusammen und wird allenfalls in einem gewissen Abstand in Richtung z von diesen Endflächen 12 homogen. Für das Einkoppeln in einen Wellenleiter 4 ist dies jedoch ohne Bedeutung.

Zur Vermeidung von Lichtverlusten beim Einkoppeln der Lichtstrahlen 13 der kompakteren Anordnung 14 in den optischen Wellenleiter 4 sollte die zum Einkoppeln vorgesehene Endfläche 42 dieses Wellenleiters 4 in einem richtigen Abstand a4 von den Auskoppelendfläche 12 der lichtleitenden Schichten 1 angeordnet sein, und die numerische Apertur der Auskoppelendfläche 12 jeder lichtleitenden Schicht 1 sollte möglichst gut an die numerische Apertur der Endfläche 42 des Wellenleiters 4 angepaßt sein.

Wie bereits erwähnt ist die numerische Apertur einer Auskoppelendfläche 12 durch den Divergenzwinkel $\theta$ des Lichtstrahls 13 bestimmt, der aus dieser Auskoppelendfläche 12 ausgekoppelt wird.

Bei gegebenen Brechzahlen n1 und n2 läßt sich der Divergenzwinkel $\theta$ des aus der Auskoppelendfläche 12 jeder lichtleitenden Schicht 1 ausgekoppelten Lichtstrahls 13 und damit die numerische Apertur dieser Auskoppelendfläche 12 mittels einer Strahlformungseinrichtung 18 dieser Schicht 1 zur Formung des in dieser Schicht 1 geführten und sich in der Schichtebene 10 dieser Schicht 1 divergent ausbreitenden Lichtstrahls 13 verändern, beispielsweise verkleinern oder gar konvergent machen, wenn dieser Winkel $\theta$ für den Wellenleiter 4 zu groß oder anderweitig nicht passend sein sollte.

Eine derartige in einer lichtleitenden Schicht 1 ausgebildete Strahlformungseinrichtung 18 zur Formung des in dieser Schicht 1 geführten Lichtstrahls 13 besteht vorteilhafterweise aus der in dieser Schicht 1 ausgebildeten reflektierenden Fläche 170, die parallel zur Schichtebene 10 dieser Schicht 1 nicht geradlinig, sondern zylinderförmig gekrümmt verläuft, beispielsweise so, daß eine konkave oder konvexe Seite der Krümmung dem der Fläche 170 zugeführten Lichtstrahl 13 zugekehrt ist. Beim Ausführungsbeispiel nach den Figuren 1 und 3 ist beispielsweise die konkave Seite der Krümmung dem der Fläche 170 zugeführten Lichtstrahl 13 zugekehrt und mit einer derart gekrümmten Fläche 170 kann der Lichtstrahl 13 kollimiert oder fokussiert werden, beispielsweise auf die Endfläche 42 eines Wellenleiters 4. Dies ermöglicht auch eine reelle optische Abbildung von Lichtquellen auf bestimmte Bildflächen in einem vorgebbaren Abbildungsmaßstab, beispielsweise die reelle optische Abbildung der Lichtaustrittsfenster 32 der Laser 30 auf die Endfläche 42 des Wellenleiters 4.

Eine Strahlformungseinrichtung 18 einer lichtleitenden Schicht 1 kann auch als eine im Strahlengang des Lichtstrahls 13 ausgebildete optische Linse realisiert sein, beispielsweise in Form einer an der Einkoppelendfläche 11 und/oder Auskoppelendfläche 12 dieser Schicht 1 ausgebildeten brechenden Linse.

Beim Ausführungsbeispiel nach den Figuren 1 bis 3 liegt die Besonderheit vor, daß die Strahlumlenkeinrichtungen 17 in Form der reflektierenden Flächen 170 der verschiedenen lichtleitenden Schichten 1 im gleichen definierten Abstand $\varepsilon 1$ von den Einkoppelendflächen 11 dieser Schichten 1 angeordnet sind. Dieser Abstand $\varepsilon 1$ ist pro lichtleitender Schicht 1 speziell der in der zur bestimmten Ebene (x, z) parallelen Richtung x gemessene Abstand zwischen der Einkoppelendfläche 11 dieser Schicht 1 und dem Punkt 132 auf der reflektierenden Fläche 170 dieser Schicht 1, in welchem der Achsstrahl des durch die Einkoppelendfläche 11 dieser Schicht 1 eingekoppelten Lichtstrahls 13 diese reflektierende Fläche 170 trifft.

Diese Vorrichtung der Umlenkeinrichtungen 17 im gleichen Abstand $\varepsilon 1$ von den Einkoppelendflächen 11 hat in dem bei allen dargestellten Ausführungsformen realisierten bevorzugten Fall, daß die Einkoppelendflächen 11 in einer gemeinsamen Ebene angeordnet sind, den Vorteil, daß sich die Achsstrahlen der an allen Umlenkeinrichtungen 17 umgelenkten Lichtstrahlen 13 in der gleichen Richtung, beispielsweise der Richtung z ausbreiten können und in der Richtung y senkrecht zur bestimmten Ebene (x, z) übereinander angeordnet sein können.

Wenn nun die Umlenkeinrichtungen 17 in einer lichtleitenden Schicht 1 beipielsweise durch eine reflektierende Fläche 170 in Form einer Flanke einer Aussparung oder Vertiefung 171 in dieser Schicht 1 realisiert wird, ist es zweckmäßig, wenn sich diese Flanke 170 über die ganze Schichtdicke dieser Schicht 1 im Bereich ihrer der weiteren Endfläche 15 erstreckt, da dann Lichtverluste bei Reflexion an dieser Flanke 170 minimal sind. Dies erfordert aber, daß die Aussparung oder Vertiefung 171 eine Tiefe t aufweist, die zumindest gleich dieser Schichtdicke ist, in der Praxis aber meist größer sein muß, damit eine reflektierende Fläche 170 ausreichend guter optischer Qualität entsteht. Es kann dazu unter Umständen erforderlich sein, die Aussparung oder Vertiefung 171 so tief zu machen, daß sie sich durch eine Zwischenschicht 2 hindurch in eine benachbarte lichtleitende Schicht 1 erstreckt.

Bei der Ausführungsform nach den Figuren 1 bis 3 würde der in dieser benachbarten Schicht 1 geführte und an der Strahlumlenkeinrichtung 17 dieser Schicht 1 reflektierte Lichtstrahl 13 unweigerlich auf den sich in diese benachbarte Schicht 1 erstreckenden Teil der Aussparung oder Vertiefung 171 treffen und könnte dort gestört werden.

Dieses Problem kann zumindest bei Lichtstrahlen 13 mit nicht zu großer Strahlbreite und/oder nicht zu großem Divergenzwinkel dadurch gelöst werden, daß die Strahlumlenkeinrichtungen 17 verschiedener lichtleitender Schichten 1 in voneinander verschiedenem Abstand $\varepsilon 1$ von den Einkoppelendflächen 11 dieser Schichten 1 angeordnet sind.

Sind die Strahlumlenkeinrichtungen 17 bzw. 170 benachbarter lichtleitender Schichten 1 in ausreichend großem verschiedenen Abstand $\varepsilon 1$ voneinander angeordnet, kann der von der Strahlumlenkeinrichtung 17 bzw. 170 einer lichtleitenden Schicht 1 reflektierte Lichtstrahl 13 weitgehend ungestört seitlich an der Strahlumlenkeinrichtungen 17 bzw. 170 der benachbarten anderen lichtleitenden Schicht 1 vorbeigehen, auf die er andernfalls treffen würde.

Dabei ist allerdings zu berücksichtigen, daß die Achsstrahlen der von den in verschiedenem Abstand $\varepsilon 1$ angeordneten Umlenkeinrichtungen 17 bzw. 170 umgelenkten Lichtstrahlen 13 die Auskoppelendflächen 12 der lichtleitenden Schichten 1 in Punkten 133 treffen müssen, die in der Richtung y senkrecht zur bestimmten Ebene (x, z) im wesentlichen übereinander angeordnet sind, damit diese Lichtstrahlen 13, wie gefordert, beim Auskoppeln aus den Auskoppelendflächen 12 zur Bildung der kompakteren Anordnung 14 dieser Lichtstrahlen 13 in dieser Richtung y übereinander angeordnet sind.

Dies bedingt, daß sich diese umgelenkten Achsstrahlen parallel zur bestimmten Ebene (x, z) nicht mehr in der gleichen, sondern in voneinander verschiedenen Ausbreitungsrichtungen ausbreiten müssen.

Diese Achsstrahlen breiten sich nach dem Auskoppeln aus den Auskoppelendflächen 12 der lichtleitenden Schichten 1 divergent zueinander aus. Dies resultiert in einem weiteren Divergenzwinkel pro einzelnem Lichtstrahl 13, der bei der Anpassung an die numerische Apertur eines Wellenleiters 4 zusätzlich zum Divergenzwinkel $\theta$ dieses einzelnen Lichtstrahls 13 selbst zu berücksichtigen ist.

Die Figur 4 zeigt ein Beispiel, die Figur 5 ein anderes Beispiel einer Ausführungsform, bei der reflektierende Flächen 170 in verschiedenem Abstand $\varepsilon 1$ voneinander angeordnet sind. Beide Ausführungsformen beziehen sich auf den Fall $\beta = 90°$, sie könnten aber ebensogut beim Fall $\beta < 90°$, insbesondere $\beta = 45°$ (Ausführungsbeispiel nach den Figuren 1 bis 3) realisiert sein.

Bei der Ausführungsform nach Figur 4 weist der Abstand $\varepsilon 1$ zwei Werte, einen kleineren und größeren, auf und die hier vereinfacht durch jeweils eine gerade Linie dargestellten reflektierenden Flächen 170 sind so angeordnet, daß sie in der Richtung z abwechselnd in dem einen und dem anderen Abstand $\varepsilon 1$ angeordnet sind.

Bei der Ausführungsform nach Figur 5 weist der Abstand $\varepsilon 1$ für jede lichtleitende Schicht 1 je einen anderen Wert auf, derart, daß die auch hier ebenfalls vereinfacht durch jeweils eine gerade Linie dargestellten reflektierenden Flächen 170 in einem in der Richtung z von reflektierender Fläche 170 zu reflektierender Fläche 170 zunehmenden Wert des Abstandes $\varepsilon 1$ angeordnet sind.

Bei beiden Ausführungsformen nach den Figuren 4 und 5 breiten sich die Achsstrahlen der von den verschiedenen reflektierenden Flächen 170 reflektierten Lichtstrahlen 13 parallel zu den Schichtebenen 10 der lichtleitenden Schichten 1 in einer von der Richtung z abweichenden Richtung z' aus, die von lichtleitender Schicht 1 zu lichtleitender Schicht 1 variiert, in der bestimmten Ebene (x, z) einen entsprechend variierenden Winkel φ mit der Richtung z einschließt und in den Figuren 4 und 5 jeweils nur für einen Lichtstrahl 13 dargestellt ist.

Es ist jedoch den Figuren 4 und 5 jeweils zu entnehmen, daß sich alle an den verschiedenen reflektierenden Flächen 170 reflektierten Lichtstrahlen 13 in voneinander verschiedenen Richtungen z' ausbreiten, derart, daß in jeder lichtleitenden Schicht 1 der Achsstrahl des reflektierten Lichtstrahls 13 seitlich mit einem Abstand an der in der Richtung z nächstfolgenden reflektierenden Fläche 170 der dieser Schicht 1 benachbarten lichtleitenden Schicht 1 vorbeigeht, so daß dieser Lichtstrahl 13 selbst weitgehend ungestört an dieser nächstfolgenden reflektierenden Fläche 170 vorbeigehen kann.

Entsprechend den verschiedenen Richtungen z' der reflektierten Lichtstrahlen 13 können sich bei den Ausführungsformen nach den Figuren 4 und 5 die reflektierenden Flächen 170 der verschiedenen lichtleitenden Schichten 1 nicht in der Richtung r2 erstrecken, die in diesem Fall mit der Richtung x identisch ist, sondern müssen sich in davon und voneinander verschiedenen anderen Richtungen r2' parallel zur Schichtebenen 10 dieser Schichten 1 erstrecken.

Dies hat zur Folge, daß bei den Ausführungsformen nach den Figuren 4 und 5 für eine reflektierende Fläche 170 nicht wie bei der Ausführungsform nach den Figuren 1 bis 3 die ganze Abmessung u der weiteren Endfläche 15 einer lichtleitenden Schicht 1 in der Richtung r2 zur Verfügung steht, sondern nur ein Teil davon. Zwar kann sich die reflektierende Fläche 170 über die ganze Abmessung v der weiteren Endfläche 15 dieser Schicht 1 in der schräg im Winkel α zur Richtung z stehenden Richtung r1 erstrecken, jedoch ist diese Abmessung v durch die vorgegebene Schichtdicke d1 dieser Schicht 1 und den Winkel α begrenzt, während eine solche Begrenzung für die Abmessung u nicht gilt, so daß diese Abmessung u größer als die Abmessung v gewählt werden kann.

Letzteres gilt strenggenommen nur unter der bei allen dargestellten Ausführungsformen angenommenen Voraussetzung, daß der Achsstrahl jedes in eine lichtleitende Schicht 1 einzukoppelnden Lichtstrahls 13 die Einkoppelendfläche 11 dieser Schicht 1 senkrecht trifft und an dieser Einkoppelendfläche 11 ungebrochen bleibt.

Letzteres ist keine notwendige Voraussetzung. Der Achsstrahl eines in eine lichtleitende Schicht 1 einzukoppelnder Lichtstrahl 13 kann auch in einem schrägen Einfallswinkel auf die Einkoppelendfläche 11 dieser Schicht 1 treffen. Er wird in diesem Fall an dieser Einkoppelendfläche 11 gebrochen und diese Brechung ist bei der Vorrichtung oder Ausbildung der Strahlumlenkeinrichtung 17 bzw. 170 dieser Schicht 1 zu berücksichtigen.

Bei richtiger Wahl dieses schrägen Einfallswinkels kann sich unter Umständen auch im Fall der Ausführungsformen nach den Figuren 4 und 5 die reflektierende Fläche 170 dieser Schicht 1 in der mit der Richtung x identischen Richtung r2 erstrecken, da der an der Einkoppelendfläche 11 dieser Schicht gebrochene Achsstrahl schräg auf diese reflektierende Fläche 170 treffen kann.

Bei der Ausführungsform nach Figur 5 liegt im Vergleich zur Ausführungsform nach Figur 4 die Besonderheit vor, daß dieser Lichtstrahl 13 bis zur Auskoppelendfläche 12 dieser Schicht 1 an allen in der Richtung z auf die nächstfolgende reflektierenden Fläche 170 folgenden reflektierenden Flächen 170 seitlich vorbeiläuft.

Die reflektierenden Flächen 170 des Ausführungsbeispiels nach Figur 5 können wie dargestellt Teil einer von den Einkoppelendflächen 11 der lichtleitenden Schichten 1 abgekehrten und zu den Schichtebenen 10 dieser Schichten 1 im wesentlichen senkrechten größeren Begrenzungsfläche 172 des ganzen Schichtenstapels sein, die parallel zu den Schichtebenen 10 dieser Schichten 1 polygonartig oder kontinuierlich gekrümmt verläuft, beispielsweise so, daß der Abstand ε1 zwischen der reflektierenden Fläche 170 im Bereich der weiteren Endfläche 15 einer lichtleitenden Schicht 1 und der Einkoppelendfläche 11 dieser Schicht 1 in dieser Richtung z laufend zunimmt.

Diese Besonderheit ist auch bei Winkeln β ungleich 90° realisierbar.

Auch bei den Ausführungsformen nach den Figuren 4 und 5 kann in einer lichtleitenden Schicht 1 eine Strahlformungseinrichtung 18 realisiert sein, beispielsweise in Form einer reflektierenden Fläche 170 im Bereich der weiteren Endfläche 15 dieser Schicht 1, die jedoch parallel zur Schichtebene 10 dieser Schicht 1 nicht geradlinig, sondern ähnlich wie bei der Ausführungsform nach den Figuren 1 bis 3 gekrümmt verläuft.

Die erfindungsgemäße Vorrichtung kann vorteilhafterweise zum Umsetzen eines Lichtstrahls 14 größeren Strahlquerschnitts Q in mehrere voneinander getrennte Teilstrahlen 13 jeweils kleineren Strahlquerschnitts q verwendet werden, wobei die Auskoppelendflächen 12 zum Einkoppeln des Lichtstrahls 14 des größeren Strahlquerschnitts Q in die lichtleitenden Schichten 1 und die Einkoppelendflächen 11 zum Auskoppeln der Lichtstrahlen 13 des jeweils kleineren Strahlquerschnitts q zu verwenden sind.

Die Herstellung der erfindungsgemäßen Vorrichtung ist besonders einfach. Die lichtleitenden Schichten 1 und Zwischenschichten 2 können auf einem Substrat in der vorgegebenen Reihenfolge aufeinanderfolgend abgeschieden werden, beispielsweise durch Abscheiden von Glas mittels Flammenhydrolyse auf einem Substrat aus Silizium.

Die weiteren Endflächen 15 können durch Abschleifen des erzeugten Schichtenstapels derart, daß eine zumindest im Winkel α zu den Schichtebenen 10 der lichtleitenden Schichten 1 stehende ebene Schlifffläche entsteht, und durch Polieren dieser Schlifffläche erzeugt werden. Die Endflächen 15 liegen frei zugänglich in dieser polierten Schlifffläche.

Die Einkoppelendflächen 11 und Auskoppelendflächen 12 können in zueinander im Winkel stehenden polierten ebenen Endflächen des Schichtenstapels liegen. Ggf. kann auch eine die reflektierenden Flächen 170 enthaltende größere Begrenzungsfläche 172 des Schichtenstapels eine polierte Schlifffläche sein.

Die Einkoppelendflächen 11, Auskoppelendflächen 12 und weiteren Endflächen 15 und ggf. die größere Begrenzungsfläche 172 des Schichtenstapels können auch durch Ätzen des erzeugten Schichtenstapels mittels Lithographie erzeugt werden.

Eine reflektierende Fläche 170 im Bereich einer weiteren Endfläche 15 einer lichtleitenden Schicht 1 in Form einer seitlichen Flanke einer in dieser Schicht 1 ausgebildeten Ausnehmung oder Vertiefung 171 kann durch lithographisches Ätzen und im Fall, daß diese reflektierende Fläche 170 parallel zur Schichtebene 10 dieser Schicht 1 geradlinig verläuft auch durch Sägen hergestellt werden.

Eine vorteilhafte Anwendung einer erfindungsgemäßen Vorrichtung ist die Konzentration der von mehreren in einer Zeile angeordneten Leistungs-Halbleiterlasern jeweils abgestrahlten Laserleistungen auf eine Endfläche einer Multimodefaser so, daß alle diese Leistungen in die Faser eingekoppelt und in dieser gebündelt fortgeleitet werden.

Jeder dieser Leistungs-Halbleiterlaser besteht nicht aus nur einem Einzelhalbleiterlaser, sondern aus deren mehreren, typischerweise 20, die dicht nebeneinander angeordnet sind und als eine Einheit betrachtet werden können.

In unmittelbarer Nähe des Lichtaustrittsfensters jedes Leistungs-Halbleiterlasers ist der Querschnitt des von ihm ausgesandten Laserstrahls, bei ausreichend kleiner Auflösung betrachtet, eine Linie. Erst mit zunehmender Entfernung vom Leistungs-Halbleiterlaser wird der Querschnitt wegen der Divergenz der einzelnen Laserstrahlen flächenhafter.

Jede Zeile weist typischerweise 7 solche Leistungs-Halbleiterlaser auf, die auf einer Geraden 31 mit Abstand voneinander angeordnet sind, es können jedoch auch mehr oder weniger sein.

In bezug auf die in Rede stehende erfindungsgemäß Anwendung sind die Leistungs-Halbleiterlaser die Halbleiterlaser 30, deren jeweils aus mehreren eng benachbart angeordneten einzelnen Lichtaustrittsfenstern der mehreren Einzellaser bestehenden Lichtaustrittsfenster 32 auf der Geraden 31 im Abstand a voneinander angeordnet sind, und der von jedem Leistungs-Halbleiterlaser 30 ausgesandte Laserstrahl bildet den Lichtstrahl 13, dessen Querschnitt in unmittelbarer Nähe des Lichtaustrittsfensters linienhaft ist und mit zunehmender Entfernung davon flächenhafter wird.

Die Multimodefaser, in die einzukoppeln ist, ist die Faser 4 mit der Endfläche 42.

Um möglichst viel von der von den Halbleiterlasern 30 abgestrahlten Laserleistung in die Faser 4 zu bringen, ist es zunächst notwendig, jeden Halbleiterlaser 30 in so geringem Abstand a3 von der Einkoppelendfläche 11 der lichtleitenden Schicht 1, in den der von diesem Laser 30 ausgesandte Lichtstrahl 13 einzukoppeln ist, anzuordnen, daß der Querschnitt dieses Strahls 13 möglichst ganz in die Einkoppelendfläche 11 dieser Schicht 1 fällt und die numerische Apertur dieser Einkoppelendfläche 11 mindestens gleich der dieses Lasers 30 ist.

Dann ist es notwendig, die aus der Auskoppelendfläche 12 jeder lichtleitenden Schicht 1 ausgekoppelte optische Leistung möglichst ganz in die Faser 4 zu bringen. Dazu darf die numerische Apertur jeder Auskoppelendfläche 12 höchstens gleich der Faser 4 sein, und der Strahlquerschnitt q des aus jeder Auskoppelendfläche 12 ausgekoppelten Lichtstrahls 13 muß in den Bereich des Kerns 40 der Endfläche 42 der Faser 4 fallen. Letzteres läßt sich vorteilhafterweise dadurch erreichen, daß die Lichtaustrittsfenster 32 der Halbleiterlaser 30, aus denen die Lichtstrahlen 13 austreten, in einem durch den Bereich des Kerns 40 der Endfläche 42 der Faser 4 bestimmten Abbildungsmaßstab kompakter auf die Endfläche 42 abgebildet werden. Dies ist bei der erfindungsgemäßen Vorrichtung durch die Strahlformungseinrichtung 18 problemlos realisierbar.

## Patentansprüche

1. Vorrichtung zur Umsetzung mehrerer Lichtstrahlen (13), die sich mit vorbestimmtem, parallel zu einer bestimmten Ebene ((x, z)) gemessenen Abstand ($\varepsilon$) voneinander ausbreiten, in eine relativ kompaktere Vorrichtung (14) dieser Lichtstrahlen (13), bestehend aus

   - mehreren lichtleitenden Schichten (1), deren jede zum Einkoppeln, Führen und Wiederauskoppeln je eines der Lichtstrahlen (13) vorgesehen ist, wobei
   - jede Schicht (1) eine Einkoppelendfläche (11) zum Einkoppeln des jeweiligen Lichtstrahls (13) in diese Schicht (1) und eine Auskoppelendfläche (12), welcher der eingekoppelte Lichtstrahl (13) in dieser Schicht (1) zugeführt ist und aus welcher dieser zugeführte Lichtstrahl (13) wieder aus der Schicht (1) auskoppelt, aufweist, wobei - die Auskoppelendflächen (12) und die aus den Auskoppelendflächen (12) ausgekoppelten Lichtstrahlen (13) in Richtung (y) senkrecht zur bestimmten Ebene ((x, z)) übereinander angeordnet sind und sich dadurch die ausgekoppelten Lichtstrahlen (13) in der kompakteren Vorrichtung (14) befinden,
   **dadurch gekennzeichnet, daß**

- die lichtleitenden Schichten (1) aus ebenen flächigen Schichten (1) bestehen, die parallel zur bestimmten Ebene ((x, z)) und in Richtung (y) senkrecht zu dieser Ebene ((x, z)) übereinander angeordnet sind, so daß sich in dieser Richtung (y) sowohl die Einkoppelendflächen (11) als auch die Auskoppelendflächen (12) der verschiedenen Schichten (1) übereinander befinden, und sich in jeder Schicht (1) der eingekoppelte Lichtstrahl (13) im wesentlichen frei ausbreitet, daß
- die Lichtstrahlen (13) unter Beibehaltung ihres zur bestimmten Ebene ((x, z)) parallelen Abstandes ($\varepsilon$) voneinander durch die Einkoppelendflächen (11) in die Schichten (1) einkoppelbar sind, und
- in jeder Schicht (1) eine Strahlumlenkeinrichtung (17) ausgebildet ist, die den in dieser Schicht (1) geführten eingekoppelten Lichtstrahl (13) so zur Auskoppelendfläche (12) dieser Schicht (1) umlenkt, daß die von allen Strahlumlenkeinrichtungen (17) umgelenkten Lichtstrahlen (13) in der Richtung (y) senkrecht zur bestimmten Ebene ((x, z)) übereinander auf die Auskoppelendflächen (12) treffen.

2. Vorrichtung nach Anspruch 1, **dadurch gekennzeichnet,** daß die Strahlumlenkeinrichtung (17) einer Schicht (1) aus einer in dieser Schicht (1) ausgebildeten und im wesentlichen senkrecht zur bestimmten Ebene ((x, z)) stehenden reflektierende Fläche (170) zum Umlenken des in dieser Schicht (1) geführten Lichtstrahls (13) in Richtung (z, z') zu deren Auskoppelendfläche (12) besteht.

3. Vorrichtung nach Anspruch 1 oder 2, **dadurch gekennzeichnet,** daß

- jede lichtleitende Schicht (1) je eine weitere Endfläche (15) aufweist, die schräg in einem Winkel ($\alpha$) zur bestimmten Ebene ((x, z)) und in einem in dieser Ebene ((x, z)) gemessenen Winkel ($\beta$) zur Einkoppelendfläche (11) dieser Schicht (1) angeordnet ist und freiliegt, und daß
- die Strahlumlenkeinrichtung (17) in jeder Schicht (1) im Bereich der weiteren Endfläche (15) dieser Schicht (1) ausgebildet ist.

4. Vorrichtung nach einem der vorhergehenden Ansprüche, **dadurch gekennzeichnet,** daß die Strahlumlenkeinrichtungen (17) der verschiedenen lichtleitenden Schichten (1) in verschiedenem Abstand ($\varepsilon1$, $\varepsilon2$) von den Einkoppelendflächen (11) dieser Schichten (1) angeordnet sind.

5. Vorrichtung nach Anspruch einem der Ansprüche 1 bis 3, **dadurch gekennzeichnet,** daß die Umlenkeinrichtungen (17) der verschiedenen lichtleitenden Schichten (1) im gleichen Abstand ($\varepsilon1$) von den Einkoppelendflächen (11) dieser Schichten (1) angeordnet sind.

6. Vorrichtung nach einem der vorhergehenden Ansprüche, **dadurch gekennzeichnet,** daß in einer lichtleitenden Schicht (1) eine Strahlformungseinrichtung (18) zur Formung des in dieser Schicht (1) geführten und sich parallel zur bestimmten Ebene ((x, z)) ausbreitenden Lichtstrahls (13) ausgebildet ist.

7. Vorrichtung nach Anspruch 2 und 6, **dadurch gekennzeichnet,** daß eine in einer lichtleitenden Schicht (1) ausgebildete Strahlformungseinrichtung (18) zur Formung des in dieser Schicht (1) geführten Lichtstrahls (13) aus der in dieser Schicht (1) ausgebildeten reflektierenden Fläche (170) besteht, die parallel zur bestimmten Ebene ((x, z)) gekrümmt verläuft.

8. Vorrichtung nach einem der vorhergehenden Ansprüche, **dadurch gekennzeichnet,** daß die Einkoppelendfläche (11) und Auskoppelendfläche (12) jeder Schicht (1) in einem Winkel ($\gamma$) zueinander stehen.

9. Vorrichtung nach einem der vorhergehenden Ansprüche, **dadurch gekennzeichnet,** daß benachbarte lichtleitende Schichten (1) durch eine zwischen diesen Schichten (1) angeordnete Schicht (2) mit einem im Vergleich zu einer Brechzahl (n1) dieser lichtleitenden Schichten (1) kleineren Brechzahl (n2) getrennt sind.

10. Anwendung einer Vorrichtung nach einem der vorhergehenden Ansprüche zur Umsetzung der von mehreren Halbleiterlasern (3) erzeugten und mit zur bestimmten Ebene ((x, z)) parallelen vorbestimmten Abstand ($\varepsilon$) voneinander sich ausbreitenden divergenten Lichtstrahlen (13) in eine relativ kompaktere Vorrichtung (14) dieser Lichtstrahlen (13).

11. Anwendung einer Vorrichtung nach einem der Ansprüche 1 bis 9 zur Umsetzung eines Lichtstrahls (14) größeren Strahlquerschnitts (Q) in mehrere mit Abstand (a) voneinander sich ausbreitenden Teilstrahlen (13) jeweils kleineren Strahlquerschnitts (q), wobei die Auskoppelendflächen (12) zum Einkoppeln des Lichtstrahls (14) des größeren Strahlquerschnitts (Q) in die lichtleitenden Schichten (1) und die Einkoppelendflächen (11) zum Auskoppeln der Teilstrahlen (13) des jeweils kleineren Strahlquerschnitts (q) zu verwenden sind.

FIG 2

FIG 3

EP 0 878 727 A2

FIG 4

EP 0 878 727 A2

FIG 5